(19) Europäisches Patentamt
European Patent Office
Office européen des brevets

(11) **EP 3 919 872 B1**

(12) **EUROPÄISCHE PATENTSCHRIFT**

(45) Veröffentlichungstag und Bekanntmachung des Hinweises auf die Patenterteilung:
**28.06.2023 Patentblatt 2023/26**

(21) Anmeldenummer: **21171223.7**

(22) Anmeldetag: **29.04.2021**

(51) Internationale Patentklassifikation (IPC):
**G01D 5/48** *(2006.01)*

(52) Gemeinsame Patentklassifikation (CPC):
**G01D 5/485**

(54) **MAGNETOSTRIKTIVER POSITIONS-SENSOR MIT DETEKTORSPULE IN EINEM CHIP**

MAGNETOSTRICTIVE POSITION SENSOR WITH DETECTOR COIL IN A CHIP

CAPTEUR DE POSITION MAGNÉTOSTRICTIF POURVU DE BOBINE DE DÉTECTION DANS UNE PUCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **04.06.2020 DE 102020114882**

(43) Veröffentlichungstag der Anmeldung:
**08.12.2021 Patentblatt 2021/49**

(73) Patentinhaber: **ASM Automation Sensorik Messtechnik GmbH**
**85452 Moosinning (DE)**

(72) Erfinder: **Klaus Manfred, Steinich**
**85604 Zorneding (DE)**

(74) Vertreter: **Weickmann & Weickmann PartmbB**
**Postfach 860 820**
**81635 München (DE)**

(56) Entgegenhaltungen:
| | |
|---|---|
| EP-A1- 2 336 730 | EP-A1- 2 396 628 |
| WO-A2-2019/169006 | DE-A1- 10 201 880 |
| DE-A1- 19 917 312 | DE-A1-102009 003 924 |
| DE-U1- 20 011 223 | US-A1- 2004 045 353 |
| US-A1- 2007 203 667 | |

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

**I. Anwendungsgebiet**

Die Erfindung betrifft Positionssensoren, insbesondere deren Detektoreinheit, basierend auf dem Prinzip der Laufzeitmessung von mechanisch-elastischen Dichtewellen (MEDW) in einem Wellenleiter, die außer diesem Wellenleiter ein relativ hierzu bewegliches, die MEDW erzeugendes oder detektierendes, Positionselement umfassen.

**II. Technischer Hintergrund**

Der Wellenleiter besteht in der Regel aus einem Rohr, einem Draht oder einem Band, und kann auch als elektrischer Leiter dienen. Der Wellenleiter kann weiterhin in einem formgebenden, linearen oder kreisförmigen, Körper aus nichtmagnetischem Material, z. B. Kunststoff oder Metall zur Aufnahme und Lagerung des Wellenleiters angeordnet sein.

Basierend auf dem Wiedemann-Effekt erzeugt ein in den Wellenleiter eingespeister Strom-Impuls bei seiner Überlagerung mit einem lateral auf den magnetostriktiven Wellenleiter gerichteten externen Magnetfeld, welches vom Positionselement, insbesondere einem Positionsmagneten herrührt, einen Torsionsimpuls einer MEDW, der sich mit etwa - je nach E-Modul oder Scher-Modulen des verwendeten Wellenleitermateriales - 2.500 m/s - 6.000 m/s vom Ort der Entstehung, also z.B. der Position des Positionselementes, in beide Richtungen im Wellenleiter ausbreitet.

An einer Stelle, üblicherweise an einem Ende des Wellenleiters, wird insbesondere der Torsionsanteil dieses mechanisch-elastischen Dichte-Impulses von einer Detektoreinheit, die sich meist in fester Position bezüglich des Wellenleiters befindet, erfasst. Die Zeitdauer zwischen der Auslösung des Erregerstromimpulses und dem Empfang dieser MEDW ist dabei ein Maß für den Abstand des verschiebbaren Positionselementes, z. B. des Positionsmagneten von der Detektoreinrichtung oder auch der Spule bzw. des Elektromagneten. Ein solcher typischer Sensor ist im US-Patent US 5590091 sowie US 5736855 beschrieben.

Ein weiterer magnetostriktiver Positions-Sensor ist aus der EP 2 396 628 A1 bekannt.

Das Hauptaugenmerk der vorliegenden Erfindung liegt auf der Detektoreinrichtung.

Diese umfasst im Stand der Technik eine Detektor-Spule, die entweder um den Wellenleiter herum angeordnet ist oder als so genannter Villary-Detektor um ein Villary-Band herum angeordnet ist, welches quer, insbesondere im 90°-Winkel, vom Wellenleiter abstrebt und mit diesem so verbunden, insbesondere mechanisch fixiert, z. B. verschweißt ist, dass der in dem Wellenleiter laufende Torsionsimpuls im Villary-Band in eine longitudinale Welle transformiert wird.

Eine solche longitudinale Welle staucht bzw. dehnt das magnetoelastische Element, also den Wellenleiter oder das Villary-Band, elastisch im kristallinen Bereich, und verändert daher dessen Permeabilität. Das Villary-Band bzw. der Wellenleiter besteht zu diesem Zweck aus Material mit möglichst hoher Änderung der magnetischen Permeabilität $\Delta\mu_r$, z. B. aus einer Nickel-Legierung, oder aus anderen geeigneten Materialien. Als Kompromiss zwischen den gesuchten Eigenschaften haben sich dabei auch sogenannte Konstantmodul-Legierungen erwiesen, bei denen der Temperaturkoeffizient des E- und/oder Scher-Modules über weite Temperaturbereiche beeinflussbar und insbesondere konstant gehalten werden kann. Dabei wird etwa die Form eines eigenstabilen Bandmaterials von etwa 0,05 - 0,2 mm Dicke und 0,5 - 1,5 mm Breite gewählt.

Wegen

$$\Delta U \approx -N \times \frac{\Delta\Phi}{\Delta t} \quad \rightarrow \quad \Delta U \approx -N \times \frac{\Delta B \times A}{-\Delta t} = N \times A \times \frac{\mu_0 \times \Delta\mu_{r \times H}}{\Delta t}$$

ist

$$\Delta U \approx \frac{\Delta\mu_r}{\Delta t} \times \text{K}$$

da die Werte für $\mu_o$, I, N, L als Konstante angenommen werden können.

Die ein magnetoelastisches Element, z.B. das Villary-Band, durchlaufende mechanisch-elastische Dichtewelle äußert sich somit in einer Spannungsänderung $\Delta U$, die als Nutzsignal an der Detektorspule abgegriffen werden kann.

Wie ersichtlich, ist das Nutzsignal $\Delta U$ umso größer, je größer die Änderung der magnetischen Permeabilität $\Delta\mu_r$ ausfällt.

Zusätzlich ist als Arbeitspunkt bzw. Arbeitsbereich ein solcher Bereich der Kurve $\Delta\mu_r$(H), also der magnetischen Permeabilität, aufgetragen über der magnetischen Feldstärke, erwünscht, in dem sich die magnetischen Permeabilität

$\Delta\mu_r$ möglichst linear, relativ zur Ursache aber möglichst stark, verändert, weshalb versucht wird, die Funktion $\Delta\mu_r$(H) in der Anstiegsflanke möglichst steil auszubilden und den Arbeitsbereich dort, im annähernd linearen Bereich, zu etablieren.

Im Stand der Technik wird zum Einstellen des Arbeitspunktes ein so genannter Bias-Magnet in Form eines Dauermagneten in räumlicher Nähe zur Detektorspule, z.B. parallel zum Villary-Band, angeordnet.

Der Arbeitspunkt der Detektoreinheit hängt neben den magnetischen Parametern des mindestens einen Bias-Magneten hauptsächlich von dessen Positionierung relativ zum Wellenleiter ab.

Nachteilig ist, dass die Detektorspulen, bei denen es primär auf die Anzahl der Windungen ankommt, bisher relativ groß sind.

Wenn sie zusätzlich noch gegen Fremdeinwirkung von Magnetfeldern durch ein Gehäuse aus ferritischem Material geschützt werden sollen, bauen sie noch entsprechend größer.

Unabhängig davon, ob solche Detektorspulen aus Draht gewickelt und separat hergestellt werden und dann auf einer Leiterplatte, auf der sich die Auswerte-Schaltung befindet, oder abseits davon angeordnet werden, benötigen die elektrischen Wege zwischen Spule und Auswerte-Schaltung eine gewisse Mindestlänge, und die Querschnitte der Leiterbahnen oder Drähte einen herstellungsbedingten Mindestquerschnitt, was wegen der dabei auftretenden elektrische Verluste, die mit dieser Größe ansteigen, ein relativ starkes Eingangssignal erfordern, welches detektiert werden soll.

Zwar steigt andererseits die Empfindlichkeit einer solchen Detektoreinheit mit der Anzahl der Wicklungen der Spule, jedoch können die vorgenannten Effekte damit nur teilweise kompensiert werden, zumal eine höhere Windungsanzahl die bauliche Größe der Detektoreinheit vergrößert.

Solche Detektorspulen dürfen das magnetostriktive Element, also den Wellenleiter oder ein hiervon quer abstrebendes sogenanntes Villary- Bändchen, nicht kontaktieren, sollen aber für ein starkes Nutzsignal möglichst nah an dem magnetostriktiven Element angeordnet werden.

Eine Detektoreinheit mit Detektorspule darf deshalb nicht verwechselt werden mit der Verwendung eines sogenannten XMR-Sensors als Detektoreinheit, der sogar an dem magnetoelastischen Element befestigt werden darf, da es sich hierbei um ein völlig anderes Funktionsprinzip als das einer Detektor-Spule handelt.

### III. Darstellung der Erfindung

#### a) Technische Aufgabe

Es ist daher die Aufgabe gemäß der Erfindung, einen magnetostriktiven Positionssensor zur Verfügung zu stellen, dessen Detektor-Einheit eine Detektor-Spule und eine elektronische Auswerte-Schaltung umfasst, wobei die Detektor-Einheit sehr klein ausgebildet sein soll, kostengünstig herstellbar sein soll und auch bei einem schwachen $\Delta\mu_r$-Eingangssignal ein ausreichendes Nutzsignal erzeugen kann.

#### b) Lösung der Aufgabe

Diese Aufgabe wird durch die Merkmale der Ansprüche 1, 15 und 16 gelöst. Vorteilhafte Ausführungsformen ergeben sich aus den Unteransprüchen.

Hinsichtlich des Position-Sensors ist die Detektor-Spule in oder auf einem Halbleiter-Substrat der Detektor-Einheit ausgebildet.

Dadurch kann eine Spule mit beispielsweise vorgegebener Windungsanzahl wesentlich kleiner ausgebildet werden, wodurch die gesamte Detektor-Einheit wesentlich kleiner als bisher sein kann.

Hierfür ist es sinnvoll, sich die damit verbundenen Dimensionen vor Augen zu halten:
Bei den bisher verwendeten, auf Elektronik-Platinen gedruckten Schaltungen (printed circuit board = PCB) besitzen die Leiterbahnen eine Breite von minimal ca. 100 $\mu$m und der Abstand der Leiterbahnen kann minimal 150 $\mu$m betragen.

Dagegen können in einem Halbleiterchip Strukturen erzeugt werden, beispielsweise Leiterbahnen oder die Breite der Windungen einer Spule, die nur 1 $\mu$m betragen, also um den Faktor 100 feiner sind.

Dementsprechend kann bei einer Flachspule bei gleichen Durchmesser die hundertfache Windungszahl erreicht werden.

Zusätzlich sind die Leiterbahnen zwischen den einzelnen elektronischen Bauelementen der integrierten Auswerte-Schaltung (IC) und auch die Länge der Verbindungsleitungen von der Detektor-Spule zur Auswerteschaltung - die vorzugsweise beide im selben Chip angeordnet sind - sind um diesen Faktor kürzer als auf einem PCB, was wiederum Vorteile bietet.

Natürlich ist die Herstellung einer Spule im Rahmen eines Chips sehr viel aufwändiger als im Rahmen einer gedruckten Schaltung, vor allem hinsichtlich des Erst-Aufwandes zum Herstellen eines solchen Chips, jedoch wird hiermit eine wesentlich höhere Sensitivität des Positions-Sensors ermöglicht und bei entsprechend hoher Stückzahl ein niedrigerer Preis.

Durch die Anordnung der Auswerte-Schaltung mit allen Bestandteilen - sei es Signalkonditionierung, Filterung, Regelung, Rauschunterdrückung - ist erfindungsgemäß die gemeinsame Unterbringung zusammen mit der Detektor-Spule in ein und demselben Chip zum einen sehr ausfallsicher, aufgrund einer geringen Anzahl von freiliegenden Verbindungen, und die gesamte Detektoreinheit ist EMVbeständiger als bei einer Lösung als PCB aufgrund der kurzen Verbindungsleitungen innerhalb des Chips.

Zum anderen wird diese Aufgabe dadurch gelöst, dass die Detektor-Spule als Flach-Spule ausgebildet ist, also in Form einer in einer Ebene liegenden Spirale, um mit den Windungen möglichst nah an den z.B. Wellenleiter herangehen zu können.

Die Detektor-Spule kann mehrere Flach-Spulen umfassen, vorzugsweise besteht sie aber aus nur einer Flach-Spule, was aufgrund der geringen Breite einer Windung möglich ist, so dass auch in nur einer einzigen Spiral-Ebene eine ausreichende Anzahl von Windungen untergebracht werden kann.

Dadurch ist nicht einmal die Anordnung von mehreren Flachspulen übereinander - die dann als Teil-Spulen elektrisch miteinander verbunden sind zu einer gemeinsamen Detektor-Spule - in dem Chip notwendig, obwohl deren axialer Abstand zwischen den Teil-Spulen dann immer noch im nur einstelligen $\mu$m-Bereich liegen würde.

Um das Nutzsignal auswerten zu können, ist es bekannt, den magnetoelastischen Effekt des Wellenleiters durch Vormagnetisierung in einen für die Auswertung günstigen Arbeitspunkt der Magnetisierungs-Kurve zu bringen, insbesondere in den möglichst linearen Bereich dieser Magnetisierungskurve.

Dafür werden ein oder mehrere Permanent-Magnete als Bias-Magnete an dem Wellenleiter angeordnet, sodass dieser im Magnetfeld der Bias-Magneten liegt, vorzugsweise ist dabei der Bias-Magnet an einer Axialposition an oder in der Nähe der Detektor-Einheit angebracht.

Da ein solcher Bias-Magnet jedoch einen makroskopischen dreidimensionalen Körper darstellt, vergrößert dies zum einen die Abmessungen der Detektor-Einheit, und das Anordnen und Befestigen, insbesondere Verkleben, ist mechanisch aufwändig.

Vorzugsweise wird im Rahmen der Erfindung deshalb das elektrische Biasing bevorzugt, welches mittels Gleichstrom oder mittels Wechselstrom durchgeführt werden kann.

Falls das Biasing mittels Gleichstrom durchgeführt werden soll, ist hierfür eine separate Biasspule, die also von der Detektorspule galvanisch getrennt ist, vorteilhaft.

Es kann jedoch auch die Detektorspule gleichzeitig als Biasspule verwendet werden, wobei dann das Biasing mittels Wechselstrom durchgeführt wird, und die Auswerte-Schaltung eine Entkoppelungs-Schaltung enthält, um das Nutzsignal von dem in die Bias-Spule eingespeisten Bias-Strom zu entkoppeln, wofür in aller Regel eine Induktivität eingesetzt wird.

Die Bias-Spule, die vorzugsweise ebenfalls eine Flach-Spule ist, verläuft vorzugsweise mit ihrer axialen Richtung, also beispielsweise der Lotrechten zu ihrer Spirale-Ebene, quer zur Wellenleiter-Richtung, insbesondere lotrecht hierzu, indem die Spirale-Ebene der Flachspule parallel zur Wellenleiter-Richtung liegt.

Aufgrund der verfügbaren Herstellung-Methoden von Halbleiter-Chips sollte es möglich sein, die Breite und/oder Dicke einer Leiterbahn, insbesondere die Wicklung einer Spule, mit einer Breite von unter 0,1 $\mu$m herzustellen, insbesondere mit einer Breite von unter 50 nm, insbesondere einer Breite von unter 10 nm, wobei bereits bei einer Breite im zweistelligen nm-Bereich die gesamte Auswerteeinheit so klein wird, dass sie problemlos innerhalb eines Schutzrohres um die Wellenleitereinheit herum untergebracht werden kann.

Um eine hohe Nutzsignal-Stärke zu erzielen, sollte die Detektor-Spule, und damit auch der gesamte Halbleiter-Chip, möglichst nah, aber nicht kontaktierend, an dem abzutastenden magnetoelastischen Element, insbesondere dem Wellenleiter, angeordnet sein, vorzugsweise mit einem Abstand von unter 10 $\mu$m, insbesondere unter 5 $\mu$m, insbesondere unter 3 $\mu$m, wobei der Abstand durch eine zwischengelegte, elektrisch nicht leitende, Trennfolie sichergestellt werden kann.

**[0043]** , Der Halbleiter-Chip, insbesondere die Detektor-Spule, kann auch in einem größeren Abstand von maximal 0,20 mm, besser maximal 0,15 mm, besser maximal 0,10 mm, zum Wellenleiter angeordnet werden, was sich insbesondere ergibt, wenn sich Wellenleiter und Halbleiter-Chip auf einander gegenüberliegenden Seiten der den Halbleiter-Chip tragenden Elektronik-Platine befinden, die auch bei Ausbildung als flexible, dünne Platine bereits eine Dicke von meist 0,10 mm besitzt. Dies ist jedoch akzeptabel, wenn die Detektor-Spule eine ausreichend große Anzahl von Windungen aufweist, insbesondere mindestens 50, besser mindestens 100, besser mindestens 200, besser mindestens 400 Windungen.

Dann kann in diesem Abstand dazwischen auch eine Elektronik-Platine, beispielsweise eine flexible oder semi-flexible Elektronik-Platine, angeordnet werden, bei der auf der einen Seite der Grundkörper der Detektor-Einheit und der Wellenleiter angeordnet ist und auf der anderen Seite ihrer Hauptebene der Halbleiter-Chip mit der Detektor-Spule und gegebenenfalls auch der Bias-Spule.

Dies hat den Vorteil einer einfachen mechanischen Herstellung, da die Befestigung der genannten Komponenten auf den verschiedenen Seiten der Platine möglich ist, ohne sich gegenseitig zu behindern. Insbesondere ist dabei der Wellenleiter nicht direkt an der Platine befestigt, sondern an dem an der Platine befestigten Grundkörper.

Auf diese Art und Weise kann die Detektor-Spule, insbesondere ausgebildet als Flachspule, in der Aufsicht auf ihre Spiralebene betrachtet, insbesondere bei einer Detektor-Spule mit einer in der Aufsicht runden Außenkontur, einen maximalen Durchmesser aufweisen, der größer ist als der Durchmesser des Wellenleiters, und somit der Durchmesser der Detektor-Spule auch bis zu 2 mm betragen, besser jedoch nur bis maximal 1,5 mm, besser noch bis maximal 0,8 mm.

Auch bei einer in der Aufsicht unrunden, insbesondere rechteckigen, Außenkontur sollte der Chip in der Aufsicht auf seine Hauptebene eine maximale Erstreckung von höchstens 2,5 mm, besser von höchstens 1.7 mm, besser von höchstens 1,0 mm aufweisen.

Die als Flach-Spule ausgebildete Detektor-Spule ist mit ihrer Spirale-Ebene vorzugsweise parallel zur Verlaufsrichtung des Wellenleiters angeordnet, um die Detektorspule nicht umfänglich um den Wellenleiter herum verlaufen lassen zu müssen und damit auf nur einer Seite des Wellenleiters anordnen zu müssen, jedoch dennoch die Windungen der Spule möglichst nah an den Wellenleiter positionieren zu können. Das gleiche gilt für ein Villary-Bändchen, falls ein solches vorhanden ist und das abzutastende magnetoelastische Element darstellt.

Bei einer Detektor-Spule, die aus mehreren Teil-Spulen besteht, die mit ihren Spirale-Ebenen beispielsweise quer zu ihrer Hauptebene beabstandet sind, sind diese vorzugsweise elektrisch in Reihe geschaltet, und den gewünschten, sich gegenseitig verstärkenden Effekt bei der Detektion der entlang des magnetoelastischen Elements ankommenden mechanischen Welle zu erzielen.

Auch der gesamte Halbleiter-Chip sollte, in der Aufsicht auf sein Hauptebene betrachtet, insbesondere auf seine Kontaktfläche zur Platine betrachtet, einen maximalen Durchmesser von höchstens 2,5 mm, besser höchstens 1,7 mm, besser höchstens 1,0 mm besitzen, um dort die Detektor-Einheit so kompakt zu bauen, dass sie in der Kopf-Hülse einer einer Schutzeinheit Platz findet, die insbesondere auch ein Tragrohr für die Wellenreiter-Einheit, das gegebenenfalls zusätzlich als elektrischer Rückleiter dient, und um die Wellenleiter-Einheit herum angeordnet ist, auf welches die Kopf-Hülse teilweise aufgeschoben ist, .

Das Substrat des Halbleiter-Chips ist vorzugsweise Silizium, obwohl auch andere Halbleiter-Materialien in Frage kommen.

Der Halbleiter-Chip wird im Rahmen der Detektor-Einheit als Bare-Chip eingesetzt, also ein Chip, der nicht von einem Gehäuse umschlossen ist, sondern der Halbleiter-Chip selbst direkt auf der Platine und der Lötflächen bzw. Leiterbahnen aufgelötet ist.

Die Elektronik-Platine, auf der der Halbleiter-Chip angeordnet, insbesondere mit dieser verlötet wird, ist, kann auch ein Platinen-Verbund aus zwei gegeneinander verklebten Teil-Platinen sein.

Dann kann in einer der beiden gegeneinander gewandten Kontakt-Seiten der beiden Teil-Platinen oder in beiden eine Längsnut eingearbeitet sein, die einen Wellenleiterkanal zwischen den beiden gegeneinander verklebten Teil-Platinen ergibt, in die der Wellenleiter eingelegt und gegebenenfalls auch befestigt werden kann.

Die Detektor-Einheit, insbesondere der Halbleiter-Chip, ist wiederum auf einer der von den Kontaktflächen abgewandten Außenflächen des Platinen-Verbundes angeordnet.

Gerade wenn die verwendete Platine eine flexible oder semi-flexible Platine ist, wird zur stabilen Gestaltung der Detektor-Einheit ein Grundkörper benötigt, der an einer der Seiten der Platine anliegt und an dieser befestigt, vorzugsweise verklebt, ist.

Dabei sollte der Wellenleiter in einem Wellenleiter-Kanal verlaufen, der zwischen dem Grundkörper und der - dann meist flexiblen - Platine ausgebildet ist, während bei dem zuvor beschriebenen Platinen-Verbund zumindest eine der Platinen als starre Elektronikplatine ausgebildet ist und hierdurch ein stabiler Grundkörper geboten wird

(Platinenverbund als Alternative)

Zu diesem Zweck kann der Grundkörper - betrachtet in Verlaufsrichtung des Wellenleiters und des Wellenleiter-Kanals - U-förmig, also Portal-förmig, ausgebildet sein und mit seinen frei endenden Schenkeln auf der Platine fixiert sein, was die Handhabung bei der Montage vereinfacht.

Alternativ kann der Grundkörper zwei Begrenzungskörper umfassen, die um den Wellenleiter-Kanal beabstandet auf der Platine fixiert werden, wobei sich vorzugsweise eine Brückenplatte auf der von der Platine abgewandten Seite der beiden Begrenzungskörper über den Wellenleiter-Kanal hinweg erstreckt, die mit beiden Begrenzungskörpern fest verbunden ist und den Grundkörper stabilisiert.

Falls das Biasing nicht elektrisch, sondern mittels Permanent-Magnet durchgeführt werden soll, ist entweder ein Bias-Magnet in dem verbindenden Schenkel des U-förmigen Grundkörpers oder in der Brückenplatte angeordnet oder je ein Bias-Magnet in den - vorzugsweise den Außenseiten - frei endenden Schenkeln des Grundkörpers oder der beiden Begrenzungskörper angeordnet und fixiert, insbesondere verklebt.

Hinsichtlich des Verfahrens zum Betreiben eines solchen Positions-Sensors wird zum elektrischen Biasing vorzugsweise das Biasing mittels Gleichstrom verwendet, da hierbei Beeinflussungen des Messergebnisses durch externe elektromagnetische Strahlungen weniger zu befürchten sind als bei Biasing mittels Wechselstrom.

Allerdings ist hierfür nicht nur eine von der Detektor-Spule separate, galvanisch getrennte, höchstens über die auswärtige Schaltung miteinander verbundene, Bias-Spule notwendig, sondern der Gleichstrom muss in diese Bias-Spule auch vollständig entkoppelt vom Nutzsignal eingebracht werden, um dieses nicht durch den Bias-Strom zu verfälschen.

Vorzugsweise wird der Bias-Strom zeitlich gepulst, insbesondere mit einem Puls während der Messung, eingebracht, um den Energiebedarf für das elektrische Biasing gering zu halten.

Hinsichtlich des Verfahrens zum Herstellen eines solchen Positions-Sensors, dessen Halbleiter-Chips mit der als Flach-Spule ausgeführten Detektor-Spule und der elektronischen Auswerte-Schaltung darin integriert, kann der Halbleiter-Chip besonders klein hergestellt werden, wenn dabei die so genannte EUV-Methode angewandt wird, also zum Belichten der Masken und/oder Schichten aus Fotolack bei der Chip-Herstellung Ultraviolett-Licht mit einer extrem kurzen Wellenlänge von beispielsweise 13,5 nm gearbeitet wird, wodurch die erzielbaren Strukturen extrem klein sind.

Da bei der klassischen Herstellung von Halbleiter-Chips mittels fotografischer Verfahren die Vorkosten für Entwurf des Maskensatzes und Herstellung der Masken sowie der dafür notwendigen Produktionsanlage sehr hoch sind, wird erfindungsgemäß vorgeschlagen, die Halbleiter-Chips durch ein Verfahren herzustellen, welches keine abdeckenden Masken für die herzustellenden Schichten des Halbleiter-Chips benötigt, indem eine nur bereichsweise benötigte Schicht, sei es aus Fotolack oder aus Halbleitermaterial

- entweder von vornherein nur in den benötigten Bereichen aufgetragen wird in flüssiger oder pastöser Form mittels Auftrags-Düse, und anschließend ausgehärtet wird
- oder als durchgehende Schicht aufgetragen wird und in den nicht benötigten Bereichen anschließend weggebrannt wird mittels eines gesteuerten energiereichen elektromagnetischen Stahles, insbesondere eines Elektronenstrahles, vorzugsweise zur Beschleunigung mittels vieler Strahlen gleichzeitig, insbesondere mit mehr als 100 oder mehr als 1000 Strahlen gleichzeitig.

Beim genannten partiellen Auftrag können zwar evtl. noch keine Strukturen im nm-Bereich bei Halbleiter-Chips hergestellt werden, sondern lediglich im einstelligen oder gar niedrigen zweistelligen $\mu$m-Bereich, was aber für den vorliegenden Zweck und aufgrund der damit verbundenen Vorteile ausreichend kleine Halbleiter-Chips ergeben könnte.

**c) Ausführungsbeispiele**

Ausführungsformen gemäß der Erfindung sind im Folgenden beispielhaft näher beschrieben.

Es zeigen:

**Figur 1a, b:**  einen Position-Sensor mit Wellenleiter-Einheit, Detektor-Einheit und Geber-Magnet, in perspektivischer Ansicht und im Längsschnitt,

**Figur 1c:**  den Position-Sensor der Figuren 1a, b in perspektivischer Ansicht, jedoch ohne Schutzrohr,

**Figur 2a - c:**  eine 1. Bauform der Detektor-Einheit in perspektivischer Ansicht schräg von oben, hierzu passender Seitenansicht und Aufsicht,

**Figur 3a - c:**  die Detektor-Einheit der Figuren 2a bis c in perspektivische Ansicht schräg von unten sowie dazu passender Seitenansicht und Ansicht von unten,

**Figur 4a - c:**  eine 2. Bauform der Detektor-Einheit in perspektiver Ansicht schräg von oben und dazu passender Seitenansicht und Aufsicht,

**Figur 5:**  eine Stirnansicht der Detektor-Einheit,

**Figur 6a - c:**  den Halbleiterchip der Detektor-Einheit in perspektiver Ansicht, Seitenansicht sowie Aufsicht.

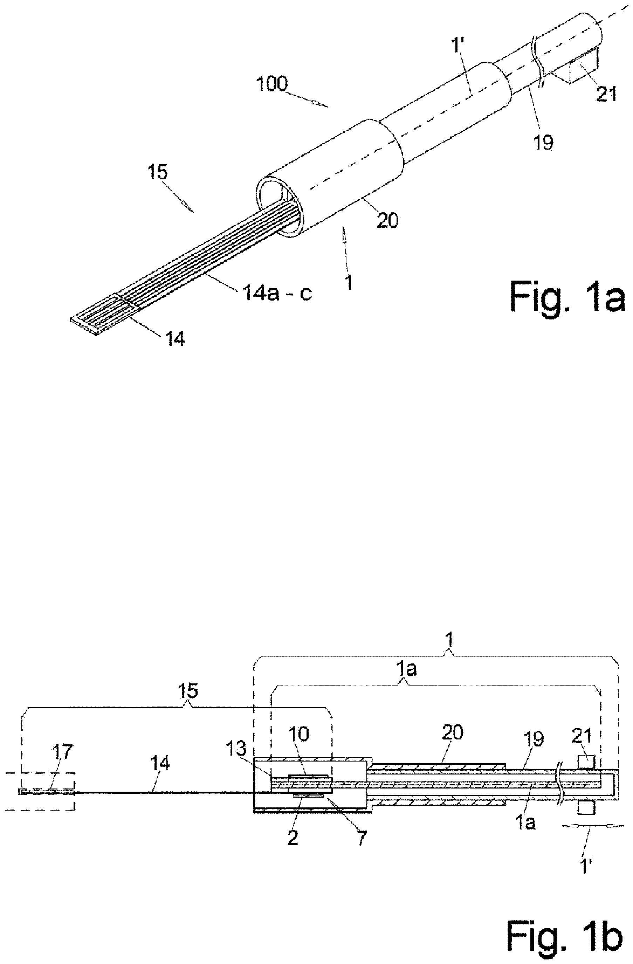

Die **Figuren 1a, b** zeigen den gesamten Position-Sensor 100 bestehend aus der Wellenleiter-Einheit 1 - dargestellt in verkürzter Form - in dem der Wellenleiter 1a als magnetostriktives Element verläuft, und der Detektor-Einheit 15, sowie dem Geber-Magneten 21, der entlang der Wellenleiter-Einheit 1 beweglich ist und dessen Position in axialer Richtung 1', der Verlaufsrichtung des Wellenleiters 1a bzw. der Wellenleiter-Einheit 1, detektiert wird.

Der Geber Magnet 21 kann die Wellenleiter-Einheit 1 ringförmig umschließen, wie in **Figur 1b** dargestellt, oder in Umfangsrichtung betrachtet nur in einem Teil des Umfangs der Wellenleiter-Einheit 1 vorhanden sein, wie in **Figur 1a** dargestellt, liegt aber in aller Regel nicht an der Wellenleiter-Einheit 1 an.

Die Wellenleiter-Einheit 1 umfasst ein Tragrohr 19, in dem der Wellenleiter 1a, in der Regel zentrisch, verläuft und gegenüber der er befestigt und auf spezielle Art und Weise gelagert ist, was jedoch für die vorliegende Erfindung ohne Belang ist.

An dem dargestellten Detektions-Ende ist auf dem Tragrohr 19 eine Kopfhülse 20 aufgesteckt, die gemeinsam einen Schutzeinheit 19+20 bilden, wobei die Kopfhülse 20 axial über das Tragrohr 19 vorsteht und in diesem Überstand einen größeren Innendurchmesser als das Tragrohr 19 aufweist, wobei die Detektor-Einheit 15 sich teilweise, nämlich mit dem Detektor-Kopf 7, noch im Bereich der Kopfhülse 20 befindet, aber aus deren am Messende offenen Ende vorsteht.

Am gegenüberliegenden Ende ist das Tragrohr 19 der Wellenleiter-Einheit 1 dagegen meist geschlossen.

Die Kopfhülse 20 vereinfacht auch die Montage, da sie erst nach dem Verbinden des aus dem Tragrohr 19 stirnseitig vorstehenden Wellenleiters 1a am Detektorkopf 7 in Position gebracht und mit dem Tragrohr 19 verbunden werden kann, etwa indem sie vor der Montage auf das Tragrohr 19 aufgeschoben und nach dem Befestigen des Wellenleiters 1a am Detektorkopf 7 über diesen geschoben und in dieser schützenden Position mit dem Tragrohr 19 verbunden beispielsweise verklebt oder vergossen werden kann.

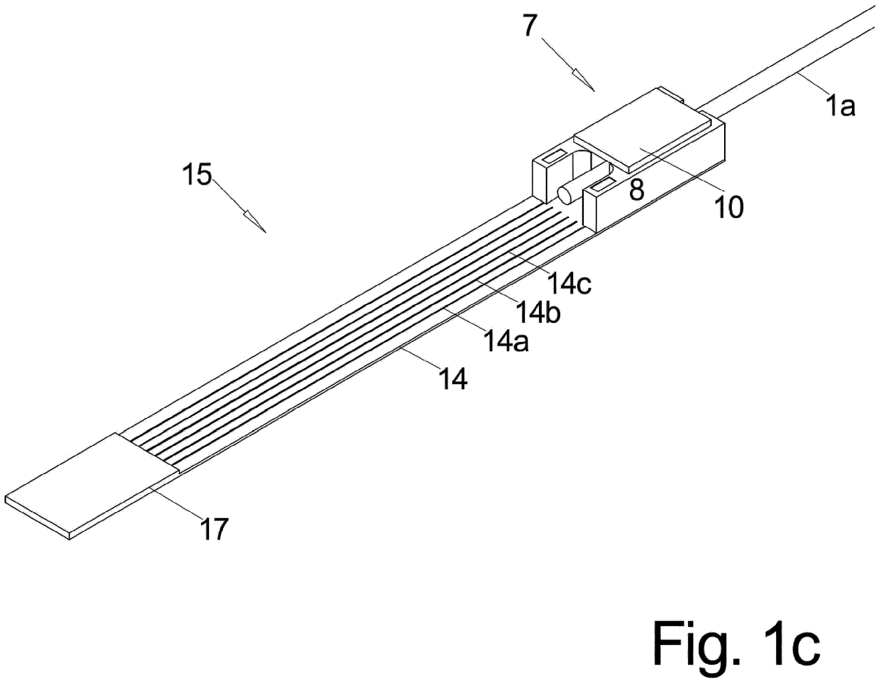

**Figur 1c** zeigt in gleicher perspektivische Ansicht wie **Figur 1a** den Position-Sensor 100 ohne Schutzeinheit, woraus ersichtlich wird, dass der Wellenleiter 1a in den Detektor-Kopf 7 nicht nur hineinragt, sondern diesen vorzugsweise über dessen gesamte axiale Länge durchläuft.

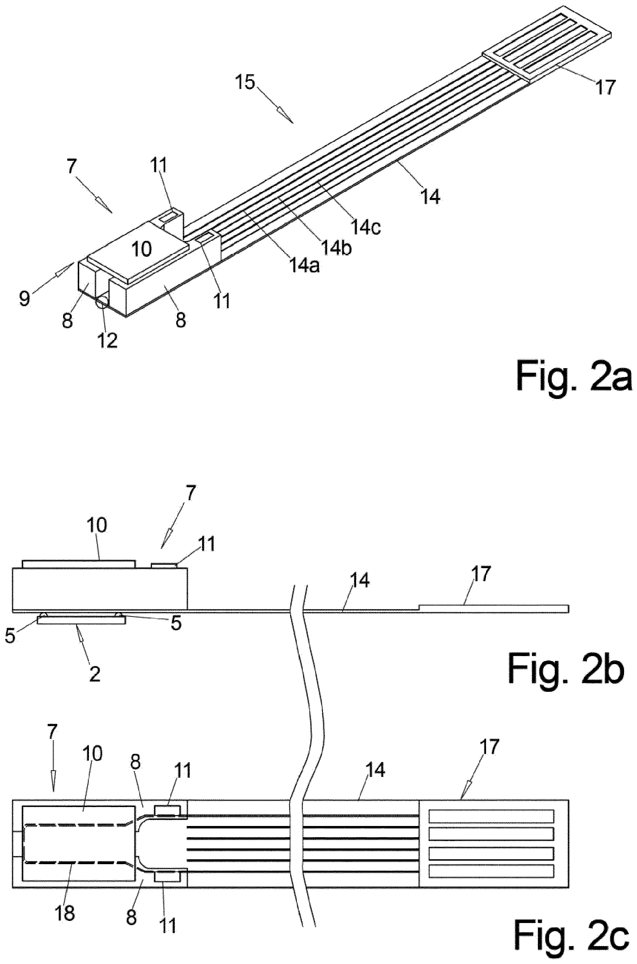

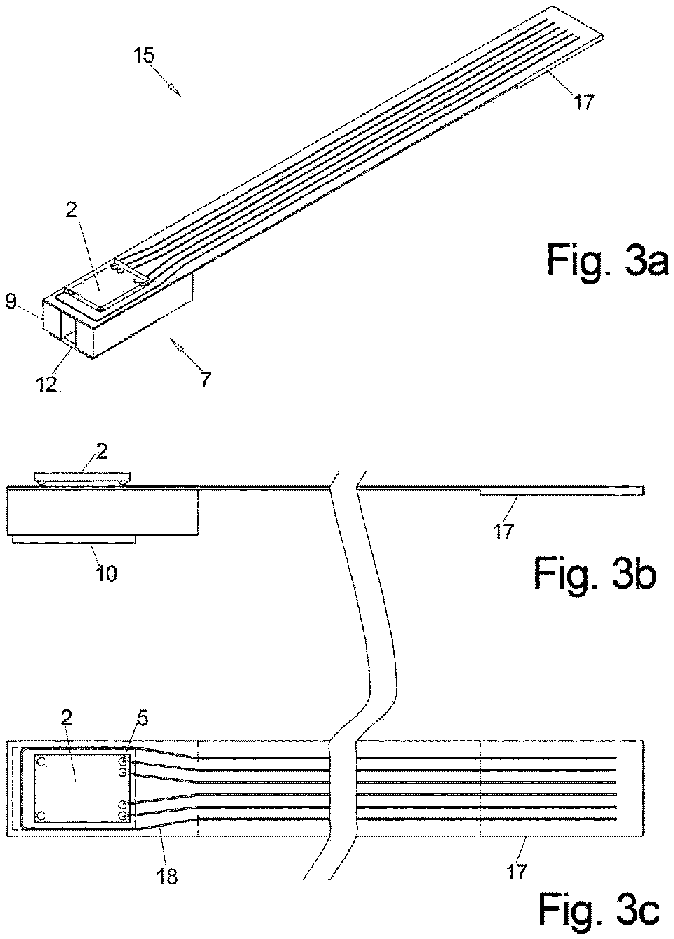

Die folgenden **Figuren 2a bis 4c** zeigen die Detektor-Einheit 15 separat und ohne daran befestigtem Wellenleiter:

Die **Figuren 2a bis 3c** zeigen eine 1. Bauform der Detektor-Einheit 15 einerseits in Ansichten von oben, andererseits in Ansichten von unten sowie die entsprechenden Seitenansichten.

Daraus wird klar, dass die Detektor-Einheit 15 aus einer streifenförmigen, vorzugsweise semi-flexiblen oder flexiblen, Elektronik-Platine 14, also einer PCB 14, besteht, an deren einem Ende, dem Messende, mittels weiterer Bauteile der Detektor-Kopf 7 ausgebildet ist und an deren anderes Ende mittels entsprechender Kontaktflächen als Stecker 17 ausgebildet ist, der auch eine auf der Platine 14 aufgebrachte Platte zur Stabilisierung der semi-flexiblen Platine 14 in diesem Steckerbereich umfassen kann.

Detektor-Kopf 7 und Stecker 17 sind über elektrisch leitende, auf der Platine 14 aufgedruckte, Leiterbahnen 14a, b, c elektrisch miteinander verbunden, die auf der Oberseite als auch auf der Unterseite oder auch nur einer der beiden Seiten ausgebildet sein können.

Der Detektor-Kopf 7 ist dadurch gebildet, dass am messeitigen Ende der streifenförmigen Platine 14 auf deren Oberseite und entlang deren Längskanten zwei, in diesem Fall quaderförmige, Begrenzungskörper 8 aufgesetzt und auf der Platine 14 fixiert sind, so dass dazwischen ein Wellenleiter-Kanal 12 entsteht, der breit genug ist, damit sich der Wellenleiter 1a dort hinein erstrecken kann.

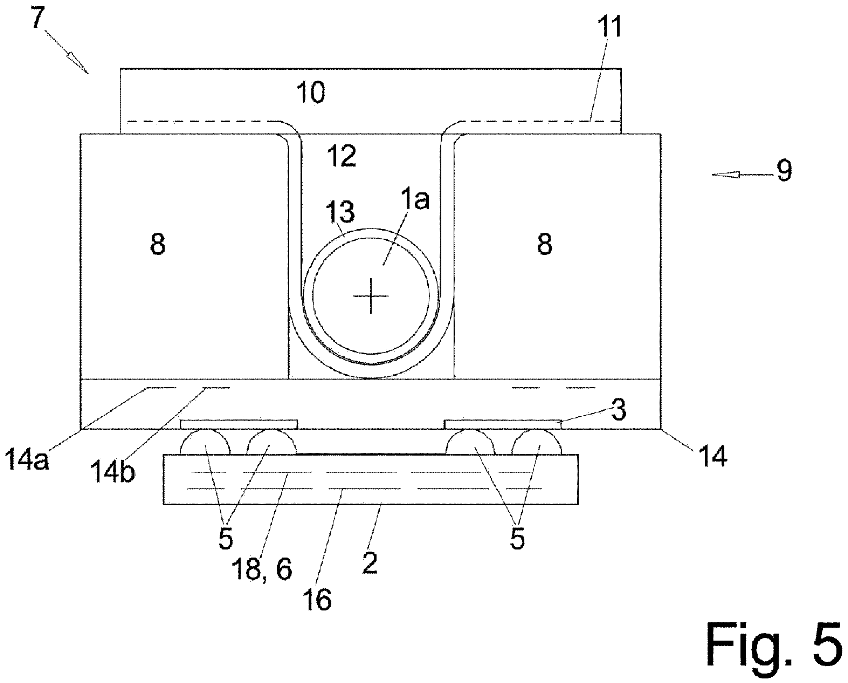

Zur Stabilisierung ist - siehe insbesondere **Figur 5** - quer über die von der Platine 14 abgewandten Oberseiten der Begrenzungskörper 8 und über den Wellenleiter-Kanal 12 hinweg eine Brückenplatte 10 auf den Begrenzungskörpern 8 befestigt, wodurch ein portalförmiger Grundkörper 9 des Detektor-Kopfes 7 gebildet wird.

Der Wellenleiter 1a ist nicht direkt an diesen Grundkörper 9 befestigt, sondern indirekt mittels eines Befestigungselements in Form eines Befestigung-Bügels 11, der in diesem Fall hutförmig ausgebildet ist - wie besten in **Figur 5** zu erkennen - und mit seinen frei abstehenden Enden auf den von der Platine 14 abgewandten Oberseiten - axial abseits der Brücken-Platte 10 - je eines der Begrenzungskörper 8 aufliegt, während sich der Mittelteil nach unten in den Wellenleiter-Kanal 12 hineinreicht bis an oder nahe der Oberseite der Platine 14.

In diesen U-förmig, nach oben offenen Mittelteil des Befestigungs-Bügels 11 liegt der Wellenleiter 1a und ist mit dem Befestigungs-Bügel 11 verbunden, insbesondere fest verbunden, insbesondere verklebt oder verklemmt und nimmt dabei einen definierten Abstand zur Oberseite der Platine 14 ein, ist jedoch mit keiner der Leiterbahnen 14a, b c der Platine 14 kontaktierend und damit elektrisch leitend verbunden. Gleiches gilt für den Befestigungs-Bügel 11.

Zu diesem Zweck ist im Bereich des Detektorkopfes 7, also im Längenbereich des Halbleiter-Chips 2 und/oder des Befestigungs-Bügels 11, um den Wellenleiter 1a herum ein Trennschlauch 13 mit einer definierten Wandstärke aus elektrisch nicht leitenden Material angeordnet, wie auch in **Figur 1b** zu erkennen.

Auf der vom Wellenleiter 1a sowie den Begrenzungskörpern 8 und damit dem Grundkörper 9 abgewandten Unterseite der Platine 14 ist ein Halbleiter-Chip 2 - vorzugsweise aus Silizium als Substrat - fixiert, indem der Chip 2 mittels der auf ihm vorhandenen so genannten Solderballs, nämlich erhabenen Lötpunkten 5, die auf der einen Seite des plattenförmigen Chips 2 ausgebildet sind, an dazu passenden Lötflächen 3 an der Unterseite der Platine 14 verlötet ist.

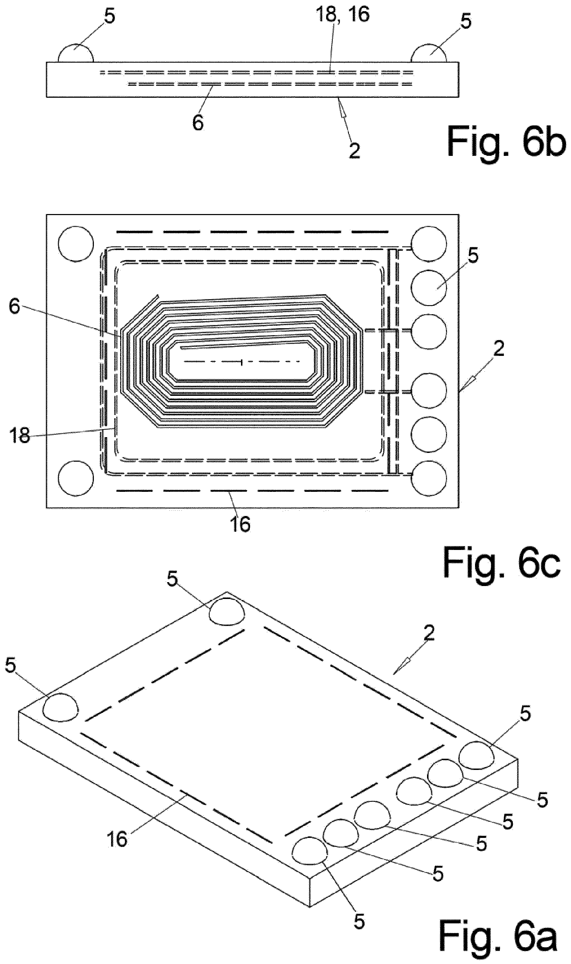

Im Inneren des plattenförmigen Halbleiter-Substrates sind - wie in den **Figuren 6a bis c** angedeutet - zur Realisierung eines Elektronik-Chips 2 wie bekannt - meist in mehreren Ebenen übereinander - miteinander zu elektronische Schaltungen verbundene elektronische Bauelemente ausgebildet.

Im vorliegenden Fall ist in dem Halbleiter-Substrat 2 zumindest eine Detektorspule 6 ausgebildet, vorzugsweise als nur in einer Ebene liegende Flachspule, und andererseits eine Auswerte-Schaltung 16, die sich in einer anderen Ebene oder auch in der gleichen Ebene neben der Detektorspule 6 befinden kann. Dabei ist die Detektorspule 6 mit der Auswerte-Schaltung 16 natürlich signaltechnisch, vorzugsweise elektrisch leitend, innerhalb des Halbleiter-Substrates 2 verbunden und die Auswerte-Schaltung 16 über die Kontaktflächen 17 die aufbereiteten Signale an ein an dem Stecker 17 angeschlossenes Bauteil, beispielsweise eine elektronische Steuerung, weitergibt.

Aufgrund der definierten Lage der Lötpunkte 5 auf dem Halbleiterchip 2 einerseits und der entsprechenden Lötflächen 3 auf der Unterseite der Platine 14 andererseits sowie dem definierten Abstand zwischen der Platine 14 und dem Chip 2 befindet sich die ebenfalls an definierter Position innerhalb des Halbleiter-Chips 2 angeordnete Detektorspule 6 in einer definierten Lage, insbesondere einem definierten Abstand, auch zum Befestigungs-Bügel 11 und damit zum Wellenleiter 1a.

Diese exakte räumliche Zuordnung ist von großer Bedeutung für die Qualität und Stärke des durch den Detektor-Kopf 7 erzielbaren Nutzsignals aus der entlang des Wellenleiters 1a am Messende und damit am Detektor-Kopf 7 ankommenden mechanischen, insbesondere longitudinalen, Welle, die durch den Gebermagneten 21 ausgelöst wurde.

Um die Qualität des Nutzsignals zu verbessern oder überhaupt ein verwertbares Nutzsignal zu erzielen, muss eine definierte Vormagnetisierung des Wellenleiters 1a vor oder während der Messung stattfinden.

Bei der 1. Bauform der Detektor-Einheit 15 gemäß der **Figuren 2a bis 3c** wird ein sogenanntes elektrisches Biasing, nämlich eine Vormagnetisierung mittels Gleichstrom, durchgeführt, wofür in dem Halbleiter-Substrat eine Bias-Spule 18 ausgebildet ist, die beaufschlagt mit Gleichstrom ein Magnetfeld erzeugt, welches die gewünschte Vormagnetisierung des im geringen Abstand darüber verlaufenden Wellenleiters 1a bewirkt.

Vorzugsweise wird die Strom-Beaufschlagung der Bias-Spule 18 von der Auswerte-Schaltung 16 vollzogen, vorzugsweise gepulst und in zeitlicher Abstimmung zu den Messungen, und hierfür muss die Bias-Spule 18 elektrisch leitend mit der Auswerteschaltung 16 verbunden sein.

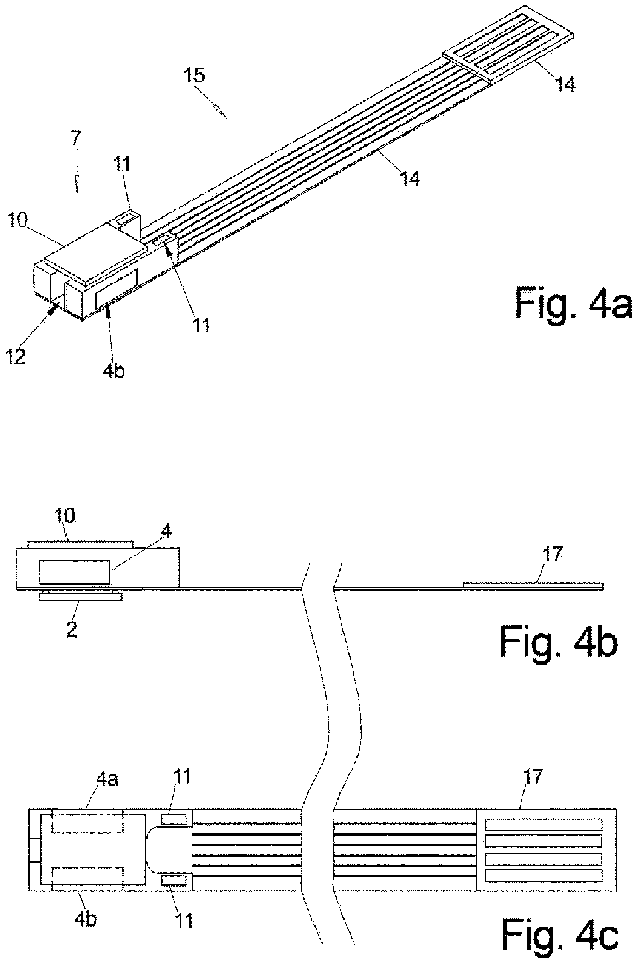

Die **Figuren 4a bis c** zeigen als 2. Bauform dagegen die klassische Art der Vormagnetisierung mittels Permanentmagnet.

Deshalb ist dort in den in oder an den beiden Begrenzungskörpern 8, insbesondere an oder in dessen jeweiligen Außenflächen, jeweils ein Bias-Magnet 4a, b angeordnet, der diese Vormagnetisierung des Wellenleiters 1a dauerhaft bewirkt.

Unter anderem zu diesem Zweck bestehen die Begrenzungskörper 8 aus einem nicht magnetischen und vorzugsweise auch nicht magnetisierbaren Material, und/oder auch nicht aus elektrisch leitfähigen Material, beispielsweise aus Kunststoff.

Bei dieser 2. Bauform ist dann natürlich keine zusätzliche Bias-Spule im Chip 2 notwendig.

BEZUGSZEICHENLISTE

| | |
|---|---|
| 1 | Wellenleiter-Einheit |
| 1a | Wellenleiter |
| 1' | Verlaufsrichtung |
| 2 | Halbleiter-Substrat, Chip |
| 3 | Lötfläche |
| 4a, b | Bias-Magnet |
| 5 | Lötpunkt, solder ball |
| 6 | Detektorspule |
| 7 | Detektorkopf |
| 8 | Begrenzungskörper |
| 9 | Grundkörper |
| 10 | Brückenplatte |
| 11 | Befestigungs-Element, Befestigungs-Bügel |
| 12 | Wellenleiter-Kanal |
| 13 | Trennfolie, Trennschlauch |
| 14 | Elektronik-Platine, PCB |
| 14a, b, c | Leiterbahn, PCB-Leitungen |
| 15 | Detektor-Einheit |
| 16 | Auswerte-Schaltung |
| 17 | Stecker, Steckerplatte, Kontaktfläche |
| 18 | DC-Bias-Spule, Bias-Spule |
| 19 | Tragrohr |
| 20 | Kopfhülse |
| 19+20 | Schutzeinheit |
| 21 | Gebermagnet |

100    Positions-Sensor

**Patentansprüche**

**1.** Magnetostriktiver **Positions-Sensor** (100) nach dem Laufzeitprinzip einer mechanisch-elastischen Dichte-Welle mit

- einer Wellenleiter-Einheit (1) mit einem magnetoelastischen Wellenleiter (1a),
- einem positionsgebenden Geber-Magneten (21), welcher kontaktlos entlang des Wellenleiters (1a) in dessen Erstreckungsrichtung (1') bewegbar ist,
- einer an einer definierten Längs-Position der Wellenleiter-Einheit (1) angeordneten Detektor-Einheit (15) mit einer als Flach-Spule ausgeführten Detektor-Spule (6) und einer elektronischen Auswerte-Schaltung (16), wobei
- die Detektor-Spule (6) in oder auf einem Halbleiter-Substrat (2) der Detektor-Einheit (15) ausgebildet ist,
- die elektronische Auswerte-Schaltung (16) in oder auf demselben Halbleiter-Substrat (2) ausgebildet ist wie die Detektor-Spule (6), und **dadurch gekennzeichnet, dass**
- das Halbleiter-Substrat ein Halbleiter-Chip (2) ist, welcher als Bare-Chip ausgebildet und montiert ist.

**2.** Positions-Sensor nach Anspruch 1,
**dadurch gekennzeichnet, dass**

- die Auswerte-Schaltung (16) möglichst nah, insbesondere parallel und beabstandet zur Spulen-Ebene (6"), an der Detektor-Spule (6) angeordnet ist;

oder/und
**dadurch gekennzeichnet, dass**

- die Detektor-Spule nur eine Flach-Spule oder mehrere Flach-Spulen (6a, 6b) umfasst.

**3.** Positions-Sensor nach einem der vorhergehenden Ansprüche,
**dadurch gekennzeichnet, dass**

- wenigstens eine Bias-Spule, in dem Halbleiter-Substrat (2), insbesondere dem Halbleiter-Chip (2), angeordnet ist,
- insbesondere die axiale Richtung der Bias-Spule quer zur Wellenleiter-Richtung verläuft,
- insbesondere die Bias-Spule an einer Längsposition nahe der Detektoreinheit angeordnet ist.

**4.** Positions-Sensor nach einem der vorhergehenden Ansprüche,
**dadurch gekennzeichnet, dass**

- ein Bias-Magnet (4) an der Detektor-Einheit, insbesondere an der dem Wellenleiter zugewandten Vorderseite einer Platine (14) der Detektoreinheit (15), angeordnet ist, oder
- in der Aufsicht auf die Platine (14) betrachtet beidseits des Wellenleiters (1) je ein Bias-Magnet (4a, b) angeordnet ist.

**5.** Positions-Sensor nach einem der vorhergehenden Ansprüche,
**dadurch gekennzeichnet, dass**

- die Breite und/oder Dicke einer Leiterbahn im Substrat in Form eines Halbleiter-Chips (2), insbesondere eine Wicklung der Spule (6), unter 0,1 $\mu$m beträgt, insbesondere unter 50 nm beträgt, insbesondere unter 10 nm beträgt,
und/oder
- die Detektor-Spule (6), insbesondere der Halbleiter-Chip (2), in einem Abstand zu dem abzutastenden magnetoelastischen Element angeordnet ist, der unter 200 $\mu$m liegt, insbesondere unter 100 $\mu$m liegt, insbesondere unter 50 $\mu$m liegt, insbesondere unter 30 $\mu$m liegt und insbesondere durch eine elektrisch nicht leitende, dazwischen gelegte Trennfolie (13), vorzugsweise in Form eines Trennschlauches (13), die den Wellenleiter umgibt, sichergestellt wird.

**6.** Positions-Sensor nach einem der vorhergehenden Ansprüche,
**dadurch gekennzeichnet, dass**

- die Detektor-Spule (6) aus mehreren, in parallelen Ebenen übereinanderliegenden Teil-Spulen besteht, und/oder
- die Detektor-Spule (6) mindestens 50 Windungen, besser mindestens 100 Windungen, besser mindestens 200 Windungen, besser mindestens 400 Windungen aufweist.

**7.** Positions-Sensor nach einem der vorhergehenden Ansprüche,
**dadurch gekennzeichnet, dass**

- die Detektor-Spule (6) sich als Flach-Spule in einer ihr zugehörigen Spiralebene erstreckt und in der Aufsicht auf ihre Spiralebene (6") einen maximalen Durchmesser von maximal 2 mm, besser von maximal 1.5. mm, besser von maximal 0,8 mm besitzt,
  und/oder
- der Halbleiter-Chip (2) in der Aufsicht auf eine ihm zugehörige Hauptebene eine maximale Erstreckung von maximal 2,5 mm, besser von maximal 1.7 mm, besser von maximal 1,0 mm besitzt.

**8.** Positions-Sensor nach einem der vorhergehenden Ansprüche,
**dadurch gekennzeichnet, dass** die Detektor-Spule (6) sich als Flach-Spule in einer/der ihr zugehörigen Spiralebene erstreckt und mit ihrer Spirale-Ebene (6") parallel zur Verlaufsrichtung des Wellenleiters (1a) angeordnet ist, wobei das gleiche für ein Villary-Bändchen gilt, falls ein solches vorhanden ist und das abzutastende magnetoelastische Element darstellt.

**9.** Positions-Sensor nach einem der vorhergehenden Ansprüche,
**dadurch gekennzeichnet, dass**

- das Halbleiter-Substrat (2) Silizium ist.

**10.** Positions-Sensor nach einem der vorhergehenden Ansprüche,
**dadurch gekennzeichnet, dass**
bei einer Realisierung der Detektor-Spule als mehrere Teil-Spulen (5a, b) diese elektrisch in Reihe geschaltet sind.

**11.** Positions-Sensor nach einem der vorhergehenden Ansprüche,
**dadurch gekennzeichnet, dass**

- der Halbleiterchip (2) auf der vom Wellenleiter abgewandten Rückseite einer/der Platine (14) der Detektor-Einheit (15) angeordnet ist, mit der zur Detektor-Spule (6) nächstliegenden Außenseite des Halbleiter-Chips (2) zur Platine (14) hin,
  und/oder
- die Platine (14) eine flexible, semi- flexible oder starre Platine ist, und/oder
- der Halbleiterchip (2) am gegenüberliegenden Ende der Platine bezüglich deren elektrischen Kontaktflächen (17), insbesondere einer Steckeranordnung (17), zur Weiterleitung der Signale angeordnet ist.

**12.** Positions-Sensor nach einem der vorhergehenden Ansprüche,
**dadurch gekennzeichnet, dass**

- eine/die Platine (14) der Detektor-Einheit (15) ein Platinen-Verbund ist aus zwei gegeneinander verklebten Teil-Platinen (14a, b),
- wobei insbesondere in wenigstens einer der beiden Teil-Platinen (14a, b) eine Längsnut vorhanden ist, in der der Wellenleiter angeordnet ist,
- wobei die Detektor-Einheit, insbesondere der Halbleiter-Chip (2), auf einer der Außenseiten des Platinen-Verbundes angeordnet ist.

**13.** Positions-Sensor nach einem der vorhergehenden Ansprüche,
**dadurch gekennzeichnet, dass**

- im Längenbereich des Halbleiter-Chips (2) auf der dem Halbleiter-Chip (2) gegenüberliegenden Vorderseite einer/der Platine (14) der Detektor-Einheit (15) ein Grundkörper (9) befestigt ist, in dem der Wellenleiter (1a) liegt,
- insbesondere der Grundkörper (9) zwei, insbesondere in der Haupt-Erstreckungsrichtung (14') der Platine (14) verlaufende, Begrenzungskörper (8) mit einem Wellenleiter-Kanal (12) dazwischen umfasst, in dem der Wellenleiter (1a) liegt,
- auf den von der Platine (14) abgewandten Seiten der beiden Begrenzungskörper (8) eine über den Wellenleiter-Kanal (12) hinweg verlaufende, den Grundkörper (9) mechanisch stabilisierende, Brückenplatte (10) befestigt ist.

14. Positions-Sensor nach Anspruch 13,
**dadurch gekennzeichnet, dass**
an oder in wenigstens einem, insbesondere beiden Begrenzungskörpern (8) und/oder der Brückenplatte (10) ein Bias-Magnet (4) angeordnet ist.

15. **Verfahren** zum Betreiben eines Positions-Sensors nach einem der vorhergehenden Ansprüche,
**dadurch gekennzeichnet, dass**
das magnetrestriktive Material, insbesondere der Wellenleiter, für die Messung der Position des Geber-Magneten in einen passenden magnetischen Arbeitspunkt gebracht wird mittels elektrischer Vormagnetisierung, indem hierfür

- entweder Wechselstrom in die Detektor-Spule (6) zeitgleich mit der Messung eingebracht wird, dessen Frequenz vorzugsweise höher liegt als die Frequenz des bei der Messung zu erwartenden elektrischen Nutzsignals, insbesondere mindestens dreimal so hoch, insbesondere mindestens zehnmal so hoch,
- oder Gleichstrom in eine separate, Bias-Spule eingebracht wird, insbesondere der Gleichstrom in die Detektorspule unter Entkoppelung vom Nutzsignal eingebracht wird.

16. **Verfahren** zum Herstellen eines Positions-Sensors nach einem der vorhergehenden Ansprüche,
**dadurch gekennzeichnet, dass**
das Halbleiter-Substrat (2) mit der darin oder darauf ausgebildeten, als Flach-Spule ausgeführten Detektor-Spule (6) und der elektronische Auswerte-Schaltung (16) als Halbleiter-Chip (2)

- unter Verwendung von Belichtungs-Masken mit der Extrem-Ultraviolett (EUV-)-Methode hergestellt wird, und/oder
- ohne Verwendung von Belichtungs-Masken hergestellt wird, indem

- eine jeweils aufgetragene Schicht, etwa aus Fotolack. gezielt bereichsweise entfernt wird mittels eines oder einer Vielzahl von energiereichen Strahlen gleichzeitig, insbesondere eines Elektronenstrahles, insbesondere mittels der Electron-Beam-Lithography-(EBL-)Methode,

und/oder
- eine nur bereichsweise aufzutragende Schicht etwa aus Fotolack nur in dem aufzutragenden Bereich aufgebracht wird mittels einer Auftrags-Düse.

## Claims

1. Magnetostrictive position sensor (100) according to the run time principle of a mechanical-elastic density wave with

- a waveguide unit (1) with a magnetoelastic waveguide (1a),
- a position-imparting encoder magnet (21) which can be moved without contact along the waveguide (1a) in the direction (1') in which it extends
- a detector unit (15) arranged at a defined longitudinal position of the waveguide unit (1) with a detector coil (6) embodied as a flat coil and an electronic evaluation circuit (16),

wherein

- the detector coil (6) is positioned in or on a semiconductor substrate (2) of the detector unit (15),
- the electronic evaluation circuit (16) is positioned in or on the same semiconductor substrate (2) as the detector coil (6), and

**characterized In that**

- the semiconductor substrate is a semiconductor chip (2) which is formed and mounted as a bare chip.

2. Position sensor according to claim 1,
   **characterized In that**

   - the evaluation circuit (16) is arranged as close as possible, in particular parallel to and spaced from, the coil plane (6"), to the detector coil (6);
   or/and

   **characterized In that**

   - the detector coil comprises only one flat coil or several flat coils (6a, 6b).

3. Position sensor according to one of the preceding claims,
   **characterized In that**

   - at least one bias coil is arranged in the semiconductor substrate (2), in particular the semiconductor chip (2),
   - in particular the axial direction of the bias coil extends transversely to the waveguide direction,
   - in particular the bias coil is arranged at a longitudinal position near the detector unit.

4. Position sensor according to one of the preceding claims,
   **characterized In that**

   - a bias magnet (4) is arranged at the detector unit, in particular at the front side of a circuit board (14) of the detector unit (15) facing the waveguide, or
   - a bias magnet (4a, b) is arranged on each side of the waveguide (1) as viewed in plan view of the printed circuit board (14).

5. Position sensor according to one of the preceding claims,
   **characterized In that**

   - the width and/or thickness of a conducting path in the substrate in the form of a semiconductor chip (2), in particular a winding of the coil (6), is less than 0.1 $\mu$m, in particular is less than 50 nm, in particular is less than 10 nm,
   and/or
   - the detector coil (6), in particular the semiconductor chip (2), is arranged at a distance from the magnetoelastic element to be scanned which is less than 200 $\mu$m, in particular is less than 100 $\mu$m, in particular is less than 50 $\mu$m, in particular is less than 30 $\mu$m, and is ensured in particular by an electrically non-conductive separating foil (13), preferably in the form of a separating tube (13), which is placed in between and surrounds the waveguide.

6. Position sensor according to one of the preceding claims,
   **characterized In that**

   - the detector coil (6) consists of a plurality of sub-coils superimposed in parallel planes,
   and/or
   - the detector coil (6) has at least 50 windings, preferably at least 100 windings, preferably at least 200 windings, preferably at least 400 windings.

7. Position sensor according to one of the preceding claims,
   **characterized In that**

   - the detector coil (6) extends as a flat coil in an associated spiral plane and, in the top view of its spiral plane (6"), has a maximum diameter of at most 2 mm, better of at most 1.5 mm, better of at most 0.8 mm,
   and/or
   - the semiconductor chip (2) has a maximum extension of at most 2.5 mm, better of at most 1.7 mm, better of at most 1.0 mm, when viewed from a main plane associated therewith.

8. Position sensor according to one of the preceding claims,

**characterized In that**
the detector coil (6) extends as a flat coil in an associated spiral plane(s) and is arranged with its spiral plane (6") parallel to the direction of extent of the waveguide (1a), the same applying to a villary strap if such is present and represents the magnetoelastic element to be scanned.

9. Position sensor according to any one of the preceding claims,
**characterized In that**

- the semiconductor substrate (2) is silicon.

10. Position sensor according to any one of the preceding claims,
**characterized In that**
when the detector coil is realized as a plurality of sub-coils (5a, b), these are electrically connected in series.

11. Position sensor according to one of the preceding claims,
**characterized In that**

- the semiconductor chip (2) is arranged on the rear side of a/the circuit board (14) of the detector unit (15) facing away from the waveguide, with the outer side of the semiconductor chip (2) closest to the detector coil (6) facing the circuit board (14),
and/or
- the circuit board (14) is a flexible, semi-flexible or rigid circuit board
and/or
- the semiconductor chip (2) is arranged at the opposite end of the board with respect to its electrical contact surfaces (17), in particular a connector unit (17), for forwarding the signals.

12. Position sensor according to one of the preceding claims,
**characterized In that**

- one/the circuit board (14) of the detector unit (15) is a circuit board composite of two partial circuit boards (14a, b) bonded to one another,
- wherein in particular in at least one of the two part-boards (14a, b) there is a longitudinal groove in which the waveguide is arranged,
- the detector unit, in particular the semiconductor chip (2), being arranged on one of the outer sides of the composite circuit board.

13. Position sensor according to one of the preceding claims,
**characterized In that**

- a base body (9), in which the waveguide (1a) is located, is fastened in the length region of the semiconductor chip (2) on the front side of a/the board (14) of the detector unit (15) opposite the semiconductor chip (2),
- in particular the base body (9) comprises two limiting bodies (8), in particular extending in the main direction of extension (14') of the circuit board (14), with a waveguide channel (12) therebetween, in which the waveguide (1a) lies,
- a bridge plate (10) extending over the waveguide channel (12) and mechanically stabilizing the base body (9) is fastened to the sides of the two limiting bodies (8) facing away from the circuit board (14).

14. Position sensor according to claim 13,
**characterized In that**
a bias magnet (4) is arranged on or in at least one, in particular both, limiting bodies (8) and/or the bridge plate (10).

15. Method for operating a position sensor according to one of the preceding claims,
**characterized In that**
the magnetically restrictive material, in particular the waveguide, is brought into a suitable magnetic operating point for measuring the position of the encoder magnet by means of electrical premagnetization, **in that** for this purpose

- either alternating current is introduced into the detector coil (6) simultaneously with the measurement, the frequency of which is preferably higher than the frequency of the useful electrical signal to be expected during the measurement, in particular at least three times as high, in particular at least ten times as high
- or direct current is introduced into a separate bias coil, in particular the direct current is introduced into the detector coil while being decoupled from the useful signal.

**16.** Method of manufacturing a position sensor according to one of the preceding claims,
**characterized In that**
the semiconductor substrate (2) with the detector coil (6) formed therein or thereon and constructed as a flat coil and the electronic evaluation circuit (16) as a semiconductor chip (2)

- is manufactured using exposure masks with the extreme ultraviolet (EUV) method
and/or
- is produced without the use of exposure masks, **in that**
- a respective applied layer, for example of photoresist, is selectively removed in certain areas by means of one or a plurality of high-energy beams simultaneously, in particular an electron beam, in particular by means of the electron beam lithography (EBL) method,
and/or
- a photoresist layer to be applied only in certain areas is applied only in the area to be applied by means of an application nozzle.

## Revendications

**1.** **Capteur de position** magnétostrictif (100) selon le principe du temps de propagation d'une onde de densité mécano-élastique, comprenant

- une unité de guide d'ondes (1) avec un guide d'ondes magnéto-élastique (1a),
- un aimant de capteur de position (21), qui peut être déplacé sans contact le long du guide d'ondes (1a) dans sa direction d'extension (1'),
- une unité de détection (15) disposée à une position longitudinale définie de l'unité de guide d'ondes (1), avec une bobine de détection (6) réalisée sous forme de bobine plate et un circuit d'évaluation électronique (16), dans lequel
- la bobine de détection (6) est formée dans ou sur un substrat semi-conducteur (2) de l'unité de détection (15),
- le circuit d'évaluation électronique (16) est formé dans ou sur le même substrat semi-conducteur (2) que la bobine de détection (6), et **caractérisé en ce que**
- le substrat semi-conducteur est une puce semi-conductrice (2) qui est conçue et montée comme une puce nue.

**2.** Capteur de position selon la revendication 1,
**caractérisé en ce que**

- le circuit d'évaluation (16) est disposé le plus près possible de la bobine de détection (6), en particulier parallèlement au plan de la bobine (6") et espacé de celui-ci ;
ou/et

**caractérisé en ce que**

- la bobine de détection ne comprend qu'une seule bobine plate ou plusieurs bobines plates (6a, 6b).

**3.** Capteur de position selon l'une des revendications précédentes,
**caractérisé en ce que**

- au moins une bobine de polarisation est disposée dans le substrat semi-conducteur (2), en particulier dans la puce semi-conductrice (2),
- en particulier la direction axiale de la bobine de polarisation s'étend transversalement à la direction du guide d'ondes,
- en particulier, la bobine de polarisation est disposée à une position longitudinale proche de l'unité de détection.

**4.** Capteur de position selon l'une des revendications précédentes,
**caractérisé en ce que**

- un aimant de polarisation (4) est disposé sur l'unité de détection, en particulier sur la face avant d'une platine (14) de l'unité de détection (15) qui est tournée vers le guide d'ondes, ou
- vu de dessus sur la platine (14), un aimant de polarisation (4a, b) est disposé de chaque côté du guide d'ondes (1).

5. Capteur de position selon l'une des revendications précédentes,
**caractérisé en ce que**

- la largeur et/ou l'épaisseur d'une piste conductrice dans le substrat sous forme de puce semi-conductrice (2), notamment un enroulement de la bobine (6), est inférieure à 0,1 $\mu$m, notamment inférieure à 50 nm, notamment inférieure à 10 nm,
et/ou
- la bobine de détection (6), en particulier la puce semi-conductrice (2), est disposée à une distance de l'élément magnétoélastique à détecter qui est inférieure à 200 $\mu$m, en particulier inférieure à 100 $\mu$m, en particulier inférieure à 50 $\mu$m, en particulier inférieure à 30 $\mu$m et qui est notamment assurée par une feuille de séparation (13) non conductrice de l'électricité, de préférence sous la forme d'un tuyau de séparation (13), qui entoure le guide d'ondes et qui est placée entre elles.

6. Capteur de position selon l'une des revendications précédentes,
**caractérisé en ce que**

- la bobine de détection (6) est constituée de plusieurs bobines partielles superposées dans des plans parallèles,
et/ou
- la bobine de détection (6) comprend au moins 50 enroulements, mieux au moins 100 enroulements, mieux au moins 200 enroulements, mieux au moins 400 enroulements.

7. Capteur de position selon l'une des revendications précédentes,
**caractérisé en ce que**

- la bobine de détection (6) s'étend sous forme de bobine plate dans un plan spiralé qui lui est associé et possède, en vue de dessus sur son plan spiralé (6"), un diamètre maximal de 2 mm au maximum, mieux de 1,5 mm au maximum, mieux de 0,8 mm au maximum,
et/ou
- la puce semi-conductrice (2) possède, en vue de dessus sur un plan principal qui lui est associé, une extension maximale de 2,5 mm au maximum, mieux de 1,7 mm au maximum, mieux de 1,0 mm au maximum.

8. Capteur de position selon l'une des revendications précédentes,
**caractérisé en ce que**
la bobine de détection (6) s'étend sous forme de bobine plate dans un/des plan(s) spiralé(s) qui lui est/sont associé(s) et est disposée avec son plan spiralé (6") parallèle à la direction d'extension du guide d'onde (1 a), dans lequel la même chose s'applique à une bandelette de Villary si elle est présente et constitue l'élément magnéto-élastique à détecter.

9. Capteur de position selon l'une des revendications précédentes,
**caractérisé en ce que**

- le substrat semi-conducteur (2) est du silicium.

10. Capteur de position selon l'une des revendications précédentes,
**caractérisé en ce que,**
lorsque la bobine de détection est réalisée sous la forme de plusieurs bobines partielles (5a, b), celles-ci sont connectées électriquement en série.

11. Capteur de position selon l'une des revendications précédentes,
**caractérisé en ce que**

- la puce semi-conductrice (2) est disposée sur la face arrière, opposée au guide d'onde, d'une/des platine(s) (14) de l'unité de détection (15), la face extérieure de la puce semi-conductrice (2) la plus proche de la bobine de détection (6) étant tournée vers la platine (14),
et/ou
- la platine (14) est une platine flexible, semi-flexible ou rigide,
et/ou
- la puce semi-conductrice (2) est disposée à l'extrémité opposée de la platine par rapport à ses surfaces de contact électrique (17), notamment un agencement de connecteurs (17), pour la transmission des signaux.

**12.** Capteur de position selon l'une des revendications précédentes,
**caractérisé en ce que**

- une/la platine (14) de l'unité de détection (15) est un assemblage de platines composé de deux platines partielles (14a, b) collées l'une contre l'autre,
- dans lequel une rainure longitudinale, dans laquelle le guide d'ondes est disposé, est notamment présente dans au moins l'une des deux platines partielles (14a, b),
- dans lequel l'unité de détection, en particulier la puce semi-conductrice (2), est disposée sur l'une des faces extérieures de l'assemblage de platines.

**13.** Capteur de position selon l'une des revendications précédentes,
**caractérisé en ce que**

- un corps de base (9), dans lequel se trouve le guide d'ondes (1a), est fixé dans la zone longitudinale de la puce semi-conductrice (2) sur la face avant d'une/des platine(s) (14) de l'unité de détection (15) opposée à la puce semi-conductrice (2),
- en particulier le corps de base (9) comprend deux corps de délimitation (8), s'étendant en particulier dans la direction d'extension principale (14') de la platine (14), avec un canal de guide d'ondes (12) entre eux, dans lequel se trouve le guide d'ondes (1a),
- sur les côtés des deux corps de délimitation (8) opposés à la platine (14) est fixée une plaque de pont (10) s'étendant sur le canal de guide d'ondes (12) et stabilisant mécaniquement le corps de base (9).

**14.** Capteur de position selon la revendication 13,
**caractérisé en ce que**
un aimant de polarisation (4) est disposé sur ou dans au moins un, en particulier les deux corps de délimitation (8) et/ou la plaque de pont (10).

**15. Procédé** de fonctionnement d'un capteur de position selon l'une des revendications précédentes,
**caractérisé en ce que**
le matériau magnétostrictif, en particulier le guide d'ondes, est amené à un point de fonctionnement magnétique approprié pour la mesure de la position de l'aimant donneur au moyen d'une prémagnétisation électrique, **en ce que**, pour ce faire,

- soit un courant alternatif est introduit dans la bobine de détection (6) en même temps que la mesure, dont la fréquence est de préférence supérieure à la fréquence du signal électrique utile attendu lors de la mesure, en particulier au moins trois fois plus élevée, notamment au moins dix fois plus élevée,
- soit un courant continu est introduit dans une bobine de polarisation séparée, en particulier le courant continu est introduit dans la bobine de détection en étant découplé du signal utile.

**16. Procédé** de fabrication d'un capteur de position selon l'une des revendications précédentes,
**caractérisé en ce que**
le substrat semi-conducteur (2) avec la bobine de détection (6) réalisée sous forme de bobine plate dans ou sur le substrat et le circuit d'évaluation électronique (16) sont réalisés sous forme de puce semi-conductrice (2)

- tout en utilisant des masques d'exposition par la méthode de l'ultraviolet extrême (EUV),
et/ou
- sans utilisation de masques d'exposition, par le fait que
- une couche respectivement appliquée, par exemple en laque photosensible, est enlevée par zones de manière ciblée au moyen d'un ou d'une pluralité de rayons riches en énergie simultanément, en particulier d'un faisceau d'électrons, notamment au moyen de la méthode de lithographie par faisceau d'électrons (EBL),
et/ou

- une couche à n'appliquer que par zones, par exemple en laque photosensible, est appliquée uniquement dans la zone à appliquer au moyen d'une buse d'application.

## Fig. 1a

## Fig. 1b

Fig. 1c

15

7   11

10

9

8   8   8

12

14c

14b

14a

11

14

17

## Fig. 2a

10   7   11

5   5

5   2

14   17

## Fig. 2b

7   10   8   11

18   8   11

14   17

## Fig. 2c

Fig. 3a

Fig. 3b

Fig. 3c

Fig. 4a

Fig. 4b

Fig. 4c

Fig. 5

Fig. 6b

Fig. 6c

Fig. 6a

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5590091 A
- US 5736855 A

- EP 2396628 A1